(19)

Europäisches
Patentamt
European
Patent Office
Office européen
des brevets

(11)     EP 2 566 037 A2

(12)                              EUROPEAN PATENT APPLICATION

(43) Date of publication:
06.03.2013  Bulletin 2013/10

(51) Int Cl.:
*H02N 1/08* (2006.01)

(21) Application number: 12173627.6

(22) Date of filing: 26.06.2012

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 26.08.2011  KR 20110085819

(71) Applicant: Samsung Electronics Co., Ltd.
Suwon-si, Gyeonggi-do, 443-742 (KR)

(72) Inventors:
• Kim, Che-heung
  Yongin-si (KR)
• Kwon, Jong-oh
  Yongin-si (KR)

(74) Representative: Portch, Daniel
Elkington and Fife LLP
Prospect House
8 Pembroke Road
Sevenoaks, Kent TN13 1XR (GB)

(54)     **Energy Conversion Device and Methods of Manufacturing and Operating the Same**

(57)     An energy conversion device, and methods of manufacturing and operating the same. The energy conversion device includes: a monolithic single-crystal silicon layer that includes a plurality of doping regions; a vibrator that is disposed in the single-crystal silicon layer and is connected to a doping region of the plurality of doping regions; a first diode that is a PN junction diode and allows an input signal applied to the vibrator to pass therethrough; and a second diode that is a PN junction diode and allows a signal output from the vibrator to pass therethrough.

FIG.  1

**Description**

FIELD OF THE INVENTION

Apparatuses and methods consistent with exemplary embodiments relate to micro conversion devices, and more particularly, to energy conversion devices and methods of manufacturing and operating the same.

BACKGROUND OF THE INVENTION

An output voltage higher than an input voltage may be obtained by using a boost converter. A charge pump and a voltage doubler are known as boost converters.

In a charge pump, since a gain is proportional to the number of stages, the number of stages provided according to steps needs to be increased in order to obtain a high gain.

In a voltage doubler, since a complementary switching signal is needed, switching loss may occur. In a charge pump and a voltage doubler, a gain in a unit stage is less than 2.

A boost converter may be manufactured on a substrate along with a circuit by using microelectromechanical systems (MEMS). However, since MEMS using a complementary metal-oxide-semiconductor (CMOS) process may use only a poly-material, MEMS have a material-related problem. In addition, a stress problem may occur according to a material and a thermal profile, and a passivation problem may also occur.

Also, related art MEMS devices are manufactured to meet specific purposes. Accordingly, it is difficult to use an existing MEMS device for purposes other than its given purpose.

SUMMARY OF THE INVENTION

One or more embodiments provide an energy conversion device that may have a high gain and high reliability and may be used for various purposes.

Further, one or more embodiments provide methods of manufacturing such an energy conversion device.

Further still, one or more embodiments provide methods of operating such an energy conversion device.

Additional aspects will be set forth in part in the description which follows and, in part, will be apparent from the description, or may be learned by practice of exemplary embodiments.

According to an aspect of an embodiment, there is provided an energy conversion device including: a monolithic single-crystal silicon layer that includes a plurality of doping regions; a vibrator disposed in the single-crystal silicon layer and is connected to a doping region of the plurality of doping regions; a first diode that is a PN junction diode and allows an input signal applied to the vibrator to pass therethrough; and a second diode that is a PN junction diode and allows a signal output from the vibrator to pass therethrough.

The single-crystal silicon layer may include a space therein that is sealed, and the vibrator is disposed in the space.

The plurality of doping regions may include first through third doping regions that are sequentially disposed, and the third doping region may include a p-type doping region and n-type doping regions that form the first and second diodes, and the energy conversion device may further include a doping region that separates a remaining portion of the third doping region and the first and second diodes.

The third doping region may include a plurality of through-holes that are connected to the space.

The energy conversion device may further include a sealing layer that is disposed on the third doping region to cover the plurality of through-holes.

The sealing layer may include a plurality of contact holes through which the first diode, the second diode, and a portion of the third doping region between the first diode and the second diode are exposed.

The energy conversion device may further include first through third electrodes that are disposed on the sealing layer to be spaced apart from each other, wherein the first through third electrodes are connected to the first diode, the second diode, and the third doping region through the plurality of contact holes.

Adjacent doping regions among the first through third doping regions may be oppositely doped.

The vibrator may include a first diaphragm and a second diaphragm that are connected to each other.

The vibrator may include a portion that is doped to have the same conductivity as a conductivity of the doping region to which the vibrator is connected, and a portion that is doped to have the same conductivity as conductivities of the doping regions to which the vibrator is not connected.

The second diaphragm may include two portions that are oppositely doped.

The first diaphragm may include a plurality of through-holes.

A doping region facing the second diaphragm and the vibrator may constitute a variable capacitor.

The second diaphragm and the doping region facing the second diaphragm may be parallel to each other at all times.

The energy conversion device may further include an insulating layer that has fixed polarization charges and is disposed on a surface of the vibrator.

According to an aspect of another embodiment, there is provided a method of operating an energy conversion device including a monolithic single-crystal silicon layer that includes a plurality of doping regions, a vibrator that is disposed in the single-crystal silicon layer and connected to a doping region of the plurality of doping regions, a first diode that is a PN junction diode and allows an input signal applied to the vibrator to pass therethrough, and a second diode that is a PN junction diode and allows a signal output from the vibrator to pass therethrough, the method including: driving the vibrator; and outputting, through the second diode, an output signal according to the driving of the vibrator.

The driving of the vibrator may include applying an input voltage to the first diode.

The method may further include applying a synchronizing signal to a region that is electrically separated from the first diode and the second diode in a doping region between the first diode and the second diode to make the output signal higher than the input voltage.

The vibrator may be driven by a force applied to the energy conversion device, and the output signal may be used as data for measuring a physical quantity of the force.

An insulating layer having fixed polarization charges may be disposed on a surface of the vibrator to use the energy conversion device as an energy harvester.

The single-crystal silicon layer may include a space therein that is sealed, and the vibrator may be disposed in the space.

The plurality of doping regions may include first through third doping regions that are sequentially disposed, wherein the third doping region includes a p-type doping region and n-type doping regions that form the first diode and the second diode, wherein the energy conversion apparatus further includes a doping region that separates a remaining portion of the third doping region and the first diode and the second diode.

The vibrator may include a region that is doped to have the same conductivity as a conductivity of the doping region to which the vibrator is connected, and a portion that is doped to have the same conductivity as conductivities of the doping regions to which the vibrator is not connected.

According to an aspect of another embodiment, there is provided a method of manufacturing an energy conversion device including: forming a first oxidized region on a first silicon layer that is single-crystal and is doped with a p-type doping material or an n-type doping material; growing, on the first silicon layer, a second silicon layer that is doped in a manner opposite to that of the first silicon layer; forming a second oxidized region that is connected to the first oxidized region and surrounds portions of the first silicon layer and the second silicon layer, wherein the portion of the second silicon layer surrounded by the second oxidized region is connected to a portion of the second silicon layer formed over the second oxidized region; growing, on the second silicon layer, a third silicon layer that is a single-crystal layer and is doped in a manner opposite to that of the second silicon layer; forming, on the portion of the second silicon layer formed over the second oxidized region, a third oxidized region that is connected to the second oxidized region, wherein the third oxidized region is formed by oxidizing a top surface of the second silicon layer; forming, on the third silicon layer, a first PN junction diode and a second PN junction diode that are spaced apart from the third oxidized region and are electrically separated from each other by a remaining portion of the third silicon layer; forming a vibrator that is spaced apart from the first silicon layer and the third silicon layer and is connected to only the second silicon layer by removing oxides of the first through third oxidized regions; and sealing portions from which the oxides are removed, wherein the second silicon layer and the third silicon layer are formed by using epitaxial growth.

The forming of the second oxidized region may include: forming a twenty first oxidized region that is connected to the first oxidized region at a position higher than a position of the first oxidized region outside the first oxidized region; and forming a twenty second oxidized region that is connected to the twenty first oxidized region to be parallel to the first oxidized region at a position higher than a position of the twenty first oxidized region over and within the first oxidized region, wherein a middle portion of the twenty second oxidized region remains as a non-oxidized portion.

The forming of the third oxidized region may include: forming, on the second silicon layer, a thirty first oxidized region that is connected to the second oxidized region at a position higher than a position of the second oxidized region; and forming, on the second silicon layer, a thirty second oxidized region that is connected to the thirty first oxidized region at a position higher than a position of the thirty first oxidized region, wherein the thirty second oxidized region is formed by oxidizing the entire second silicon layer between the thirty first oxidized region and the third silicon layer.

The thirty second oxidized region may extend to the third silicon layer.

The forming of the first and second PN junction diodes may include: forming a first n-type doping region that is connected to the second silicon layer and is spaced apart from the third oxidized region on the third silicon layer at a side of the third oxidized region; forming a second n-type doping region that is connected to the second silicon layer and is spaced apart from the first n-type doping region on the third silicon layer between the third oxidized region and the first n-type doping region, wherein the second n-type doping region is formed on the third silicon layer at the side of the third oxidized region to be connected to the second silicon layer; forming a third n-type doping region that is not connected to the second n-type doping region and the second silicon layer outside the second n-type doping region on the third silicon layer at another side of the third oxidized region; and forming a p-type doing region on the first n-type doping region formed on the third silicon layer at the one side of the third oxidized region, wherein the first n-type doping region and the second n-type doping region are simultaneously formed.

The forming of the vibrator may include: forming through-holes, through which the third oxidized region is exposed, in the third silicon layer; and wet etching oxides of the first through third oxidized region through the through-holes.

The first through third oxidized regions may be formed by: implanting oxygen ions; and annealing a resultant structure obtained after the oxygen ions are implanted.

The sealing may include forming a sealing layer that is formed on the third silicon layer to seal the through-holes.

The method may further include: forming on the sealing layer a plurality of through-holes, through which the first PN junction diode and the second PN junction diode are exposed and the third silicon layer between the first PN junction diode and the second PN junction diode is exposed; and forming on the sealing layer a first electrode that is connected to the exposed first PN junction diode, a second electrode that is connected to the exposed second PN junction diode, and a third electrode that is connected to the exposed third silicon layer.

BRIEF DESCRIPTION OF THE EMBODIMENTS

These and/or other aspects will become apparent and more readily appreciated from the following description of embodiments, taken in conjunction with the accompanying drawings of which:

FIG. 1 is a cross-sectional view illustrating an energy conversion device according to an embodiment;
FIG. 2 is an equivalent circuit of the energy conversion device of FIG. 1;
FIG. 3 is a cross-sectional view illustrating a moment when a second diaphragm contacts a first doping region in the energy conversion device of FIG. 1;
FIGS. 4 through 16 are cross-sectional views illustrating a method of manufacturing an energy conversion device, according to one or more embodiments; and
FIGS. 17 through 19 are cross-sectional views illustrating cases where an energy conversion device is used as various devices according to one or more embodiments.

DETAILED DESCRIPTION OF THE DRAWINGS

Exemplary embodiments will now be described more fully with reference to the accompanying drawings. Thicknesses of layers or regions shown in the drawings are exaggerated for clarity.

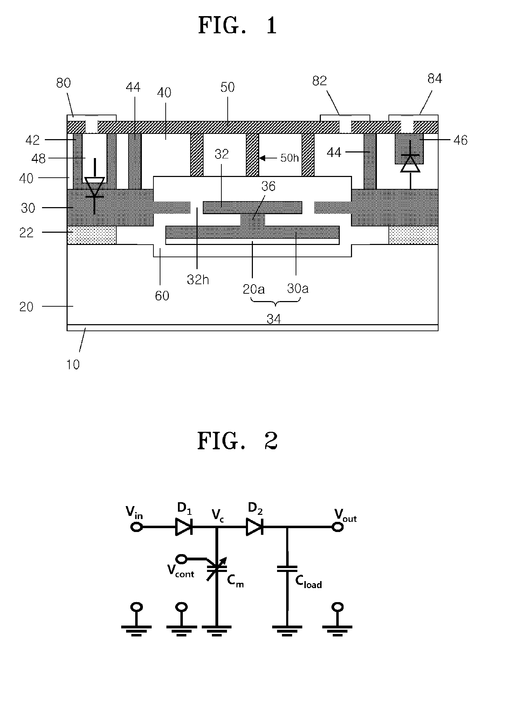

FIG. 1 is a cross-sectional view illustrating an energy conversion device according to an embodiment.

Referring to FIG. 1, the energy conversion device, which is a single layer including a monolithic three-dimensional (3D) structure, does not include a clear interface or a contact surface between layers. The energy conversion device includes a first doping region 20, a second doping region 30, a third doping region 40, first and second sealing layers 22 and 50, first and second diaphragms 32 and 34, and a space 60 having a predetermined volume. A lower electrode plate 10 is attached to a bottom surface of the first doping region 20. First through third electrodes 80, 82, and 84 are disposed on the second sealing layer 50.

The first doping region 20 is a region doped with a p-type doping material, though it is understood that another embodiment is not limited thereto. For example, according to another embodiment, the first doping region 20 may include an n-type doping material instead of the p-type doping material. The second doping region 30 is disposed on the first doping region 20. The second doping region 20 is a region doped with an n-type doping material, though it is understood that another embodiment is not limited thereto. For example, according to another embodiment, the second doping region 20 may include a p-type doping material instead of the n-type doping material. The first and second diaphragms 32 and 34 extend from the second doping region 30. Accordingly, the first and second diaphragms 32 and 34 may be portions of the second doping region 30.

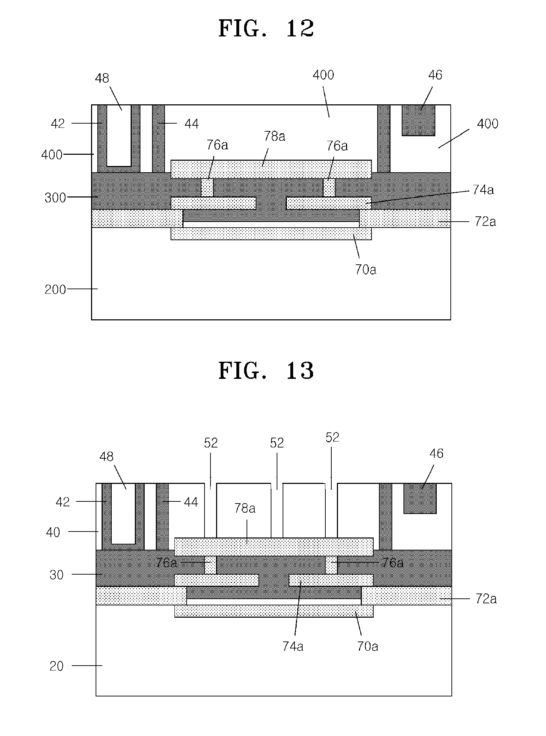

The first sealing layer 22 is disposed between the first and second doping regions 20 and 30. The first sealing layer 22 is connected to the first and second doping regions 20 and 30. The first sealing layer 22 is disposed on a portion of the first doping region 20. The first sealing layer 22 may be, for example, a silicon oxide layer. The third doping region 40 is disposed on the second doping region 30. A portion of the third doping region 40 is connected to the second doping region 30. The third doping region 40 includes a plurality of through-holes 52 (see FIG. 13) formed (i.e., located) therein. The plurality of through-holes 52 are connected to the space 60.

The second sealing layer 50 is formed on the third doping region 40. The second sealing layer 50 is filled in the plurality of through-holes 52 and covers the plurality of through-holes 52. It is understood that the second sealing layer 50 may be filled in all or some of the plurality of through-holes 52. The third doping region 40 may include fourth, fifth, and sixth doping regions 42, 44, and 46 that are spaced apart from one another in a horizontal direction. Doping materials of the fourth, fifth, and sixth doping regions 42, 44, and 46 may be the same as a doping material of the second doping region 30. The fourth and fifth doping regions 42 and 44 are connected to the second doping region 30. The sixth doping region 46 is spaced apart from the second doping region 30. The third doping region 40 is disposed between the second doping region 30 and the sixth doping region 46. Since the third doping region 40 and the sixth doping region 46 are silicon regions respectively doped with p-type and n-type materials, the third doping region 40 and the sixth doping region 46 may constitute a PN junction diode (hereinafter, referred to as a second diode).

The plurality of through-holes 52 are formed between the fifth doping regions 44, which are spaced apart from each other. The fourth doping region 42 is connected to the second doping region 30, and is surrounded by the third doping region 40. The fourth doping region 42 may include a seventh doping region 48. The seventh doping region 48 may be disposed within the fourth doping region 42. The seventh doping region 48 contacts the second sealing layer 50, and a bottom and a side wall of the seventh doping region 48 are surrounded by the fourth doping region 42. The seventh doping region 48 may be a silicon region doped with a p-type doping material. The fourth doping region 42 may be a silicon region doped with an n-type doping material. Accordingly, the fourth doping region 42 and the seventh doping region 48 may constitute a PN junction diode (hereinafter, referred to as a first diode).

The fifth doping regions 44 are regions for separating the first diode and the second diode in the third doping region 40. Directions of the first diode and the second diode may be opposite to each other. The first diode and the second diode are connected to each other through the first diaphragm 32. The space 60 is formed between the first doping region 20 and the third doping region 40. The space 60 may be disposed under the plurality of through-holes 52. The space 60 may be a place where the first diaphragm 32 and the second diaphragm 34 vibrate. The space 60 is sealed by the first doping region 20, the second doping region 40, the first sealing layer 22, and the second sealing layer 50. The first diaphragm 32 and the second diaphragm 34 are connected to each other via a connection pillar 36. The first diaphragm 32 is disposed over the second diaphragm 34. The first diaphragm 32 and the second diaphragms 34 may serve as a single vibrator 32+34.

Before the energy conversion device starts operating, the first diaphragm 32 and the second diaphragm 34 may be parallel to each other. While the energy conversion device operates, the first diaphragm 32 and the second diaphragm 34 may vibrate in the space 60. The first diaphragm 32 and the second diaphragm 34 may vibrate due to an electrical signal applied to the energy conversion device, momentum applied to the energy conversion device, or an external physical force or impact for accelerating the energy conversion device. Though the first diaphragm 32 vibrates in the space 60, the first diaphragm 32 and the third doping region 40 are sufficiently spaced apart from each other so as not to contact each other. The first diaphragm 32 and the second doping region 30 may be disposed at the same level in the horizontal direction. The first diaphragm 32 is connected to the second doping region 30. The first diaphragm 32 may be a portion of the first doping region 30. A plurality of through-holes 32h may be formed in the first diaphragm 32.

The connection pillar 36 may be formed of the same material as that of the first diaphragm 32. The second diaphragm 34 may be disposed at the same level as the first sealing layer 22 in the horizontal direction. The second diaphragm 34 and the first doping region 20 are spaced apart from each other. While the energy conversion device operates, the second diaphragm 34 may instantly contact the first doping region 20. The second diaphragm 34 may include a lower layer 20a and an upper layer 30a disposed on the lower layer 20a. The lower layer 20a and the upper layer 30a are monolithic and connected to each other. The lower layer 20a and the upper layer 30a may be formed of the same material and may be doped with different doping materials. The lower layer 20a may be formed of the same material as that of the first doping region 20, for example, a single-crystal silicon layer. The lower layer 20a is doped with the same doping material as that of the first doping region 20. The upper layer 30a may be formed of the same material as that of the second doping region 30. The upper layer 30a may be doped with the same doping material as that of the second doping region 30.

Since the second diaphragm 34 includes the lower layer 20a, which is formed of the same material and has the same doping characteristics as those of the first doping region 20, when the second diaphragm 34 contacts the first doping region 20 while the energy conversion device operates, a PN junction capacitor is instantly formed, thereby obtaining a relatively high capacitance. The second sealing layer 50 formed on the third doping region 40 covers the fourth through seventh doping regions 42, 44, 46, and 48. A plurality of contact holes are formed in the second sealing layer 50. The sixth doping region 46 and the seventh doping region 48 are exposed through the plurality of contact holes. A top surface of the third doping region 40 between the plurality of through-holes 52 and the fifth doping region 44 adjacent to the sixth doping region 46 is exposed through one of the plurality of contact holes.

First through third electrodes 80, 82, and 84 that are spaced apart from one another are disposed on the second sealing layer 50. The first electrode 80 contacts the seventh doping region 48 through one of the plurality of contact holes. A voltage may be applied to the energy conversion device through the first electrode 80. The second electrode 82 contacts the third doping region 40 through one of the plurality of contact holes. A predetermined voltage or a specific external signal may be applied to the energy conversion device through the second electrode 82. The third electrode 84 contacts the sixth doping region 46 through one of the plurality of contact holes. A voltage, for example, a boosted voltage, output from the energy conversion device may be output to the outside through the third electrode 84.

FIG. 2 is an equivalent circuit of the energy conversion device of FIG. 1.

In FIG. 2, a first diode $D_1$ corresponds to the first diode described with reference to FIG. 1, and a second diode $D_2$ corresponds to the second diode described with reference to FIG. 1. The first diode $D_1$ and the second diode $D_2$ are arranged as shown in FIG. 2. If the first through seventh doping regions 20, 30, 40, 42, 44, 46, and 48 in FIG. 1 are oppositely doped, the first diode $D_1$ and the second diode $D_2$ in FIG. 2 may be oppositely arranged. In FIG. 2, a capacitor $C_m$, that is, a variable capacitor, corresponds to a capacitor formed by the vibrator 32+34, the first doping region 20, and a gap between the vibrator 32+34 and the first doping region 20 of FIG. 1. A capacitor $C_{load}$ is a load capacitor (not shown) outside the energy conversion device of FIG. 1. Also, in FIG. 2, $V_{in}$ is an input voltage applied to the first electrode 80 of FIG. 1, and $V_{cont}$ is a voltage applied to the second electrode 82 of FIG. 1. $V_{out}$ is an output voltage output to the outside through the third electrode 84 of FIG. 1. Also, $V_c$ of FIG. 2 is a voltage applied to the vibrator 32+34 of FIG. 1. Since a voltage and a capacitance are inversely proportional to each other and the vibrator 32+34 is an element of the capacitor $C_m$, the voltage $V_c$ varies according to a vibration of the vibrator 32+34 as time passes.

An operation of the energy conversion device of FIG. 1 will be briefly explained with reference to FIG. 2.

The input voltage $V_{in}$ is applied and the capacitor $C_m$ is charged. When a capacitance of the capacitor $C_m$ is a maximum capacitance and charge is constant, the voltage $V_c$ is increased in proportion to a change rate of the capacitance of the capacitor $C_m$ according to a vibration of the vibrator 32+34. In this case, the first diode $D_1$ is reverse biased to the voltage $V_c$ and the second diode $D_2$ is forward biased to the voltage $V_c$. Accordingly, the capacitor $C_{load}$ is charged by charges of the capacitor $C_m$ through the second diode $D_2$, to have a potential of the voltage $V_c$. Such an event continuously occurs while the vibrator 32+34 vibrates and the capacitance of the capacitor $C_m$ changes between a maximum value and a minimum value. Accordingly, if the vibrator 32+34 vibrates faster than a time constant of a circuit, the direct current (DC) output voltage $V_{out}$ having a ripple but higher than the input voltage $V_{in}$ may be obtained. The output voltage $V_{out}$ may be defined by:

$$V_{out} = [C_m(max)/\ C_m(min)]V_{in} \qquad \dots \text{(Equation 1)}.$$

In Equation 1, $C_m(max)$ denotes the maximum capacitance of the capacitor $C_m$, and $C_m(min)$ denotes a minimum capacitance of the capacitor $C_m$.

A capacitance of a general capacitor is proportional to an area of electrodes constituting the general capacitor and is inversely proportional to an interval between the electrodes. Accordingly, when a gap between the second diaphragm 34 and the first doping region 20 is maximized, the capacitance of the capacitor $C_m$ is minimized.

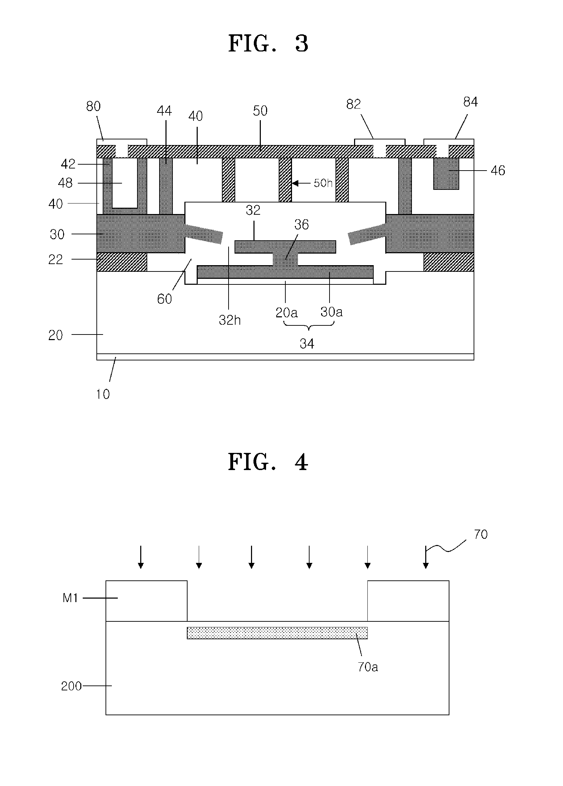

A time when the capacitance of the capacitor $C_m$ is maximized is when the second diaphragm 34 contacts the first doping region 20 as shown in FIG. 3. At this time, a PN junction occurs between the vibrator 32+34 and the first doping region 20. Accordingly, the capacitor $C_m$ has a junction capacitance. The junction capacitance may be determined according to a doping concentration and a magnitude of a reverse bias voltage applied to the PN junction formed between the first doping region 20 and the vibrator 32+34, which instantly contact each other. Since the doping concentration is adjusted to have a breakdown voltage higher than a reverse bias voltage applied to the PN junction, the junction capacitance may be determined accordingly. When the junction capacitance is obtained in this manner, a capacitance ratio higher than a capacitance ratio that may be obtained by reducing an interval between electrodes in an existing capacitor having a parallel plate structure may be achieved. Accordingly, the energy conversion device may boost a voltage higher than a related art energy conversion device. That is, the energy conversion device may have a gain higher than that of a related art energy conversion device.

As shown in FIG. 3, when the vibrator 32+34 is driven, the first diaphragm 32 is bent, and the second diaphragm 34 is not bent and is maintained parallel to the first doping region 20. Even when the first diaphragm 32 is bent upward, the second diaphragm 34 and the first doping region 20 are continuously maintained parallel to each other. Accordingly, as the second diaphragm 34 is driven, an interval between the first doping region 20 and a surface of the second diaphragm 34 facing the first doping region 20 may be changed. However, when the second diaphragm 34 is located at an arbitrary position, an interval between the first doping region 20 and the second diaphragm 34 may be prevented from varying according to portions of the surface. Accordingly, when the second diaphragm 34 is located at an arbitrary position, a capacitance obtained at the position may be maximized.

FIGS. 4 through 16 are cross-sectional views illustrating a method of manufacturing an energy conversion device, according to one or more embodiments. In this case, the same elements as those illustrated in FIGS. 1 through 3 are denoted by the same reference numerals, and a redundant explanation thereof will not be given.

Referring to FIG. 4, a first mask M1 is formed on a first silicon layer 200 doped with a p-type doping material. The first silicon layer 200 may be a single-crystal silicon layer, and may have, for example, a given crystal direction of <111>. According to another embodiment, the first silicon layer 200 may be doped with an n-type doping material instead of the p-type doping material. An exposed portion of a top surface of the first silicon layer 200 is limited by the first mask M1. Oxygen ions 70 are implanted into the exposed portion of the top surface of the first silicon layer 200. Next, the first silicon layer 200 into which the oxygen ions 70 are implanted is annealed. Accordingly, a first oxidized region 70a is formed under the top surface of the first silicon layer 200. A portion disposed between the top surface of the first silicon layer 200 and the first oxidized region 70a of the first silicon layer 200 corresponds to the lower plate 20a of the second diaphragm 34 of FIG. 1. A depth, a thickness, and a width of the first oxidized region 70a may vary according to patterning of the first mask M1 and ion implantation conditions (for example, implantation energy). After the first oxidized region 70a is formed, the first mask M1 is removed.

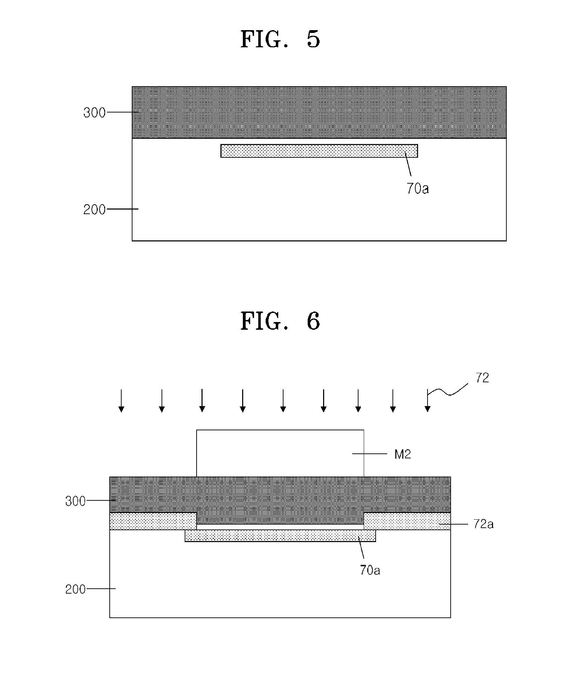

Referring to FIG. 5, a second silicon layer 300 is formed on the first silicon layer 200 including the first oxidized region 70a. The second silicon layer 300 may be a single-crystal silicon layer. The second silicon layer 300 may be doped in a manner opposite to that of the first silicon layer 200. For example, when the first silicon layer 200 is doped with a p-type doping material, the second silicon layer 300 may be doped with an n-type doping material. The second silicon layer 300 may be formed via epitaxial growth. The second silicon layer 300 may be formed in situ, and may be doped while being formed. A portion of the second silicon layer 300 becomes the vibrator 32+34 of FIG. 1. Accordingly, when the second silicon layer 300 is formed, a thickness of the second silicon layer 300 may be determined by considering that a portion of the second silicon layer 300 becomes the vibrator 32+34 of FIG. 1. In FIG. 5, a boundary line is illustrated between the first silicon layer 200 and the second silicon layer 300 for convenience of explanation. However, since the second silicon layer 300 is formed via epitaxial growth, there is actually no boundary line between the first silicon layer 200 and the second silicon layer 300. Accordingly, the first silicon layer 200 and the second silicon layer 300 are monolithic.

Referring to FIG. 6, a second mask M2 is formed on the second silicon layer 300. The second mask M2 is disposed over the first oxidized region 70a. The second mask M2 is formed over and within the first oxidized region 70a, and an edge of the first oxidized region 70a may be located around the second mask M2. When the second mask M2 exists, oxygen ions 72 are implanted into a top surface of the second silicon layer 300. A resultant structure obtained after the oxygen ions 72 are implanted is annealed. Next, the second mask M2 is removed. Second oxidized regions 72a that are spaced apart from each other are formed between the first silicon layer 200 and the second silicon layer 300 due to the implantation of the oxygen ions 72 and the annealing. The second oxidized regions 72a are formed on opposite sides of the first oxidized region 70a at positions higher than that of the first oxidized region 70a. Each of the second oxidized regions 72a includes an upper portion of the first silicon layer 200 and a lower portion of the second silicon layer 300 outside the first oxidized region 70a. Each second oxidized region 72a extends to an edge of the first oxidized region 70a to contact the first oxidized region 70a. A position of each second oxidized region 72a may be determined by patterning of the second mask M2 and ion implantation energy of the oxygen ions 72. A portion of a silicon oxide layer of each second oxidized region 72a may be used as the first sealing layer 22. Accordingly, each second oxidized region 72a may be thicker than an oxidized region subsequently formed or the first oxidized region 70a so as to partially remain after subsequent wet etching.

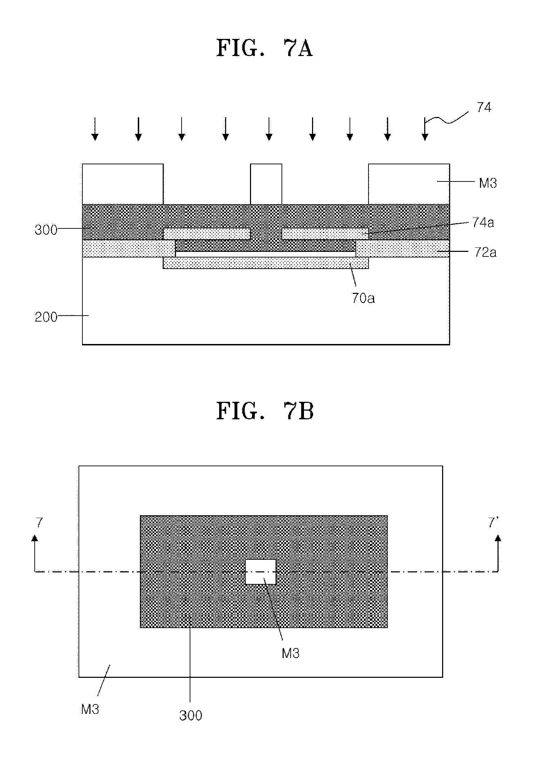

FIG. 7A is a cross-sectional view taken along a line 7-7' of FIG. 7B, and FIG. 7B is a top plan view of FIG. 7A.

Referring to FIGS. 7A and 7B, after the second oxidized region 72a is formed, a third mask M3 is formed on the second silicon layer 300. The third mask M3 may be, for example, a photosensitive film pattern, like the first mask M1 and the second mask M2.

The third mask M3 exposes a portion of the top surface of the second silicon layer 300 corresponding to the first oxidized region 70a. As shown in FIG. 7B, a middle portion of the exposed portion of the top surface of the second silicon layer 300 is covered by the third mask M3. The middle portion of the exposed region of the top surface of the second silicon layer 300 covered by the third mask M3 corresponds to the connection pillar 36 of FIG. 1 to be formed in a subsequent process. After the third mask M3 is formed in this manner, oxygen ions 74 are implanted into the exposed portion of the top surface of the second silicon layer 300. Next, the third mask M3 is removed, and a resultant structure obtained after the oxygen ions 74 are implanted is annealed. Accordingly, a third oxidized region 74a is formed in the second silicon layer 300. The third oxidized region 74a is formed at a position higher than positions of the second oxidized regions 72a. The third oxidized region 74a is disposed over and laterally within the first oxidized region 70a. A portion of the second silicon layer 300 that is not oxidized is disposed at a center of the third oxidized region 74a. Accordingly, the third oxidized region 74a allows the portion of the second silicon layer 300 that is not oxidized to be disposed at the center of the third oxidized region 74a and surrounds the portion of the second silicon layer 300 that is not oxidized. The third oxidized region 74a is connected to the second oxidized region 72a.

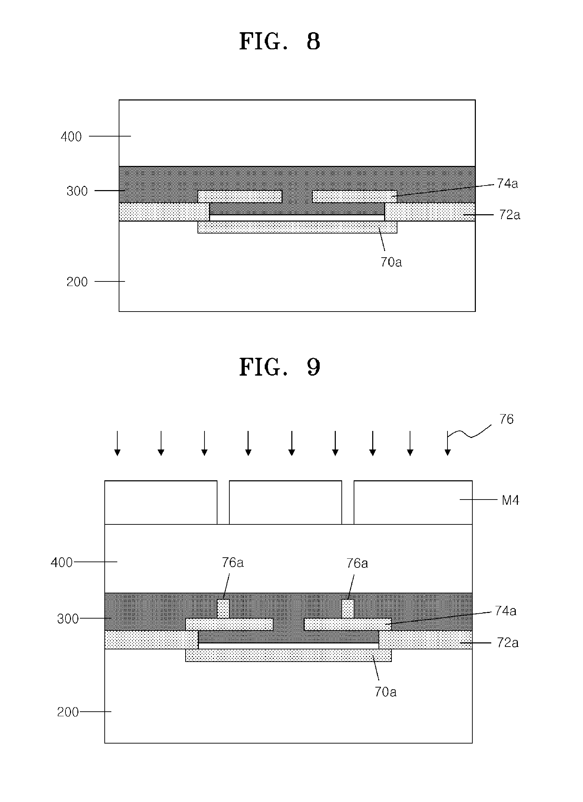

Referring to FIG. 8, a third silicon layer 400 is formed on the second silicon layer 300 in which the third oxidized region 74a is disposed. The third silicon layer 400 may be a single-crystal silicon layer. The third silicon layer 400 may be doped with the same doping material as that of the first silicon layer 200. The third silicon layer 400 may be formed via epitaxial growth. While the third silicon layer 400 is grown, the third silicon layer 400 may be doped. The third silicon layer 400 may be formed and doped in situ. Since the third silicon layer 400 is formed via epitaxial growth, the third silicon layer 400 may be continuously grown from the second silicon layer 300. Accordingly, the third silicon layer 400 and the second silicon layer 300 may be formed to be monolithic, and there is no interface or contact surface between the second silicon layer 300 and the third silicon layer 400.

Referring to FIG. 9, a fourth mask M4 through which a portion of a top surface of the third silicon layer 400 is exposed is formed on the third silicon layer 400. The fourth mask M4 may be a photosensitive film pattern. The portion of the top surface of the third silicon layer 400 exposed through the fourth mask M4 corresponds to a portion of the second silicon layer 300 formed over the third oxidized region 74a. That is, the fourth mask M4 defines the portion of the second silicon layer 300 disposed over the third oxidized region 74a.

When the fourth mask M4 is formed, oxygen ions 76 are implanted into the top surface of the third silicon layer 400. The oxygen ions 76 reach the second silicon layer 300 through the exposed portion of the top surface of the third silicon layer 400, and the oxygen ions 76 are implanted into the portion of the second silicon layer 300 formed over the third oxidized region 74a. The oxygen ions 76 may reach the portion of the second silicon layer 300 formed over the third oxidized region 74a by adjusting ion implantation energy of the oxygen ions 76. After the oxygen ions 76 are implanted, the fourth mask M4 is removed. Next, a resultant structure obtained after the oxygen ions 76 are implanted is annealed. Accordingly, fourth oxidized regions 76a are formed in/of the portion of the second silicon layer 300 formed over the third oxidized region 74a. The fourth oxidized regions 76a may be formed perpendicularly to the third oxidized region 74a. The fourth oxidized regions 76a may be formed at two places to be symmetric about the center of the third oxidized region 74a. The fourth oxidized regions 76a are connected to the third oxidized region 74a. Although the fourth oxidized regions 76a are formed in the second silicon layer 300, the fourth oxidized regions 76a may extend to the top surface of the second silicon layer 300 to contact the third silicon layer 400. The fourth oxidized regions 76a may be formed before the third silicon layer 400 is formed.

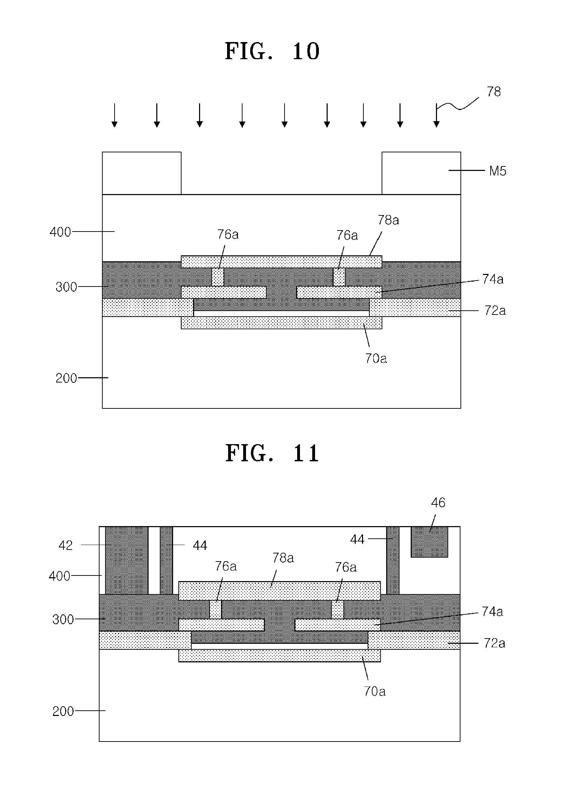

Referring to FIG. 10, a fifth mask M5 that defines a region where a fifth oxidized region 78a is to be formed is formed on the third silicon layer 400. Oxygen ions 78 are implanted into the region defined by the fifth mask M5. In this case, the oxygen ions 78 may reach the region where the fifth oxidized region 78a is to be formed by adjusting ion implantation energy of the oxygen ions 78. After the oxygen ions 78 are implanted, the fifth mask M5 is removed. Next, a resultant structure obtained after the oxygen ions 78 are implanted is annealed. Accordingly, the fifth oxidized region 78a is formed as shown in FIG. 10.

Referring to FIG. 11, the fourth doping region 42, the fifth doping regions 44, and the sixth doping region 46 are formed on the third silicon layer 400. The fourth through sixth doping regions 42, 44, and 46 may be formed through ion implantation by implanting the same doping material, for example, an n-type doping material, and by performing heat treatment for diffusion. When the fourth through sixth doping regions 42, 44, and 46 are n-type doping regions, the fourth through sixth doping regions 42, 44, and 46 may be respectively referred to as a first n-type doping region 42, a second n-type doping region 44, and a third n-type doping region 46. The fourth through sixth doping regions 42, 44, and 46 are spaced apart from one another. The fourth doping region 42 and the fifth doping region 44 may be simultaneously formed. The sixth doping region 46 may be formed before or after the fourth doping region 42 and the fifth doping region 44 are formed. The fourth and fifth doping regions 42 and 44 are formed on the second silicon layer 300 to be connected to each other. The sixth doping region 46 is formed to be spaced apart from the second silicon layer 300. The fifth doping regions 44 may be formed to face each other with the fifth oxidized region 78a therebetween. That is, the fifth doping regions 44 are disposed around the fifth oxidized region 78a. The fourth doping region 42 and the sixth doping region 46 are disposed outside the fifth doping regions 44. The fourth doping region 42 is disposed at a left side of the fifth doping regions 44, and the sixth doping region 46 is disposed at a right side of the fifth doping regions 44. The fourth and fifth doping regions 42 and 44 may extend from the second silicon layer 300 to the top surface of the third silicon layer 400.

Referring to FIG. 12, the seventh doping region 48 is formed on the fourth doping region 42. The seventh doping region 48 may be formed by implanting a doping material, for example, a p-type doping material, through ion implantation into a portion of the fourth doping region 42, and by performing heat treatment for diffusion. The seventh doping region 48 is spaced apart from circumferential portions of the fourth doping region 42. A top surface of the seventh doping region 48 may be a portion of the top surface of the third silicon layer 400. The fourth doping region 42 and the seventh doping region 48 are regions doped with opposite doping materials. The second silicon layer 300 and the fourth doping region 42 are single-crystal silicon layers having the same doping material. Accordingly, the fourth doping region 42 and the seventh doping region 48 may form a PN diode. Also, since the sixth doping region 46 includes a silicon layer doped with a p-type material and the third silicon layer 400 doped with an n-type material surrounds the sixth doping region 46, the sixth doping region 46 and the third silicon layer 400 formed around the sixth doping region 46 may form a PN diode. The fifth doping regions 44 may be regions formed to separate the two PN junction diodes in the third silicon layer 400.

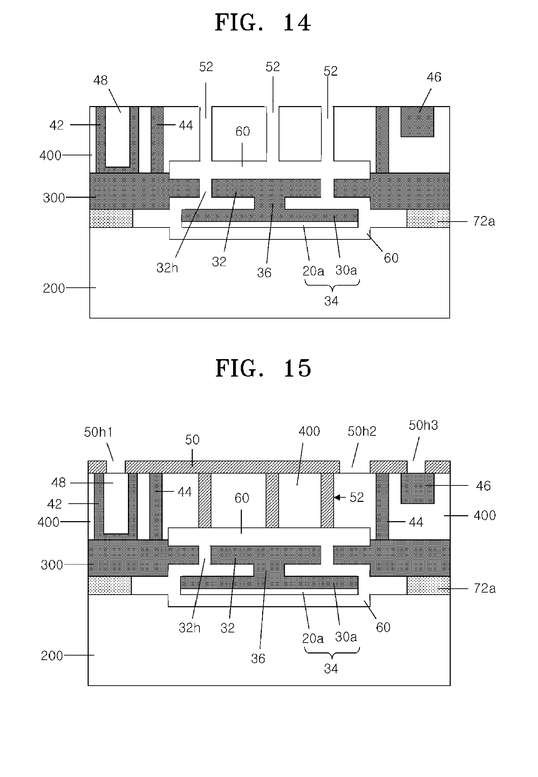

Referring to FIG. 13, the plurality of through-holes 52 are formed in a portion of the third silicon layer 400 between the fifth doping regions 44, that is, over the fifth oxidized region 78a. A portion of the fifth oxidized region 78a is exposed through the plurality of through-holes 52. Next, silicon oxides of the first through fifth oxidized regions 70a, 72a, 74a, 76a, and 78a are removed through the plurality through-holes 52. As a result, as shown in FIG. 14, one space 60 is formed in the first through fifth oxidized regions 70a, 72a, 74a, 76a, and 78a. The silicon oxides of the first through fifth oxidized regions 70a, 72a, 74a, 76a, and 78a may be removed by performing wet etching on a resultant structure of FIG. 13. For example, the silicon oxides of the first through fifth oxidized regions 70a, 72a, 74a, 76a, and 78a may be removed by dipping the resultant structure of FIG. 13 for a predetermined period of time in a container containing a wet etchant having a relatively high etch selectivity with respect to the silicon oxides, for example, a hydrofluoric acid (HF) solution.

Referring to FIG. 14, after the space 60 is formed, the plurality of through-holes 52 become inlet holes of the space 60. The vibrator 32+34 including a portion of the first silicon layer 200 that corresponds to the lower layer 20a and portions of the second silicon layer 300 that correspond to the first diaphragm 32 and the second diaphragm 34 and the connection pillar 36, surrounded by the first through fifth oxidized regions 70a, 72a, 74a, 76a, and 78a, is formed in the space 60. The vibrator 32+34 includes the first diaphragm 32 and the second diaphragm 34. The first diaphragm 32 and the second diaphragm 34 have already been explained with reference to FIG. 1, and thus a redundant explanation thereof will not be repeated.

While the resultant structure of FIG. 13 is wet etched, the silicon oxide of the second oxidized regions 72a, which is thicker than those of the other oxidized regions 70a, 74a, 76a, and 78a, may partially remain even after the silicon oxides of the other oxidized regions 70a, 74a, 76a, and 78a are removed, or may be completely removed. After the wet etching, if portions of the second oxidized regions 72a remain, the portions may be used as the first sealing layer 22. If the second oxidized regions 72a are completely removed via the wet etching, inlets of portions from which the second oxidized regions 72a are removed may be sealed during subsequent sealing.

Referring to FIG. 15, the second sealing layer 50 is formed on the third silicon layer 400 to cover the plurality of through-holes 52. The second sealing layer 50 may be formed by using zero-level vacuum sealing. The second sealing layer 50 may be, for example, a silicon oxide layer or a silicon nitride layer. When the second sealing layer 50 is formed, the plurality of through-holes 52 may be filled. After the second sealing layer 50 is formed, a plurality of contact holes 50h1, 50h2, and 50h3 are formed in the second sealing layer 50. The seventh doping region 48 is exposed through the first contact hole 50h1. A portion of the third silicon layer 400 between the fifth doping regions 44 is exposed through the second contact hole 50h2. The sixth doping region 46 is exposed through the third contact hole 50h3.

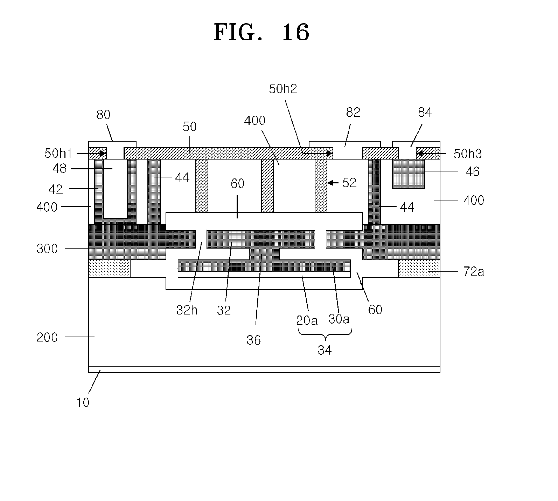

Referring to FIG. 16, the first through third electrodes 80, 82, and 84, which are spaced apart from one another, are formed on the second sealing layer 50. The lower electrode 10 is formed on a bottom surface of the first silicon layer 200. The first electrode 80 is filled in the first contact hole 50h1 and contacts the seventh doping region 48. The second electrode 82 is filled in the second contact hole 50h2 and contacts the third silicon layer 400. The third electrode 84 is filled in the third contact hole 50h3 and contacts the sixth doping region 46. Accordingly, the energy conversion device is manufactured.

A method of driving an energy conversion device according to an embodiment will now be explained. From the explanation, it is understood that the energy conversion device may be used for various purposes.

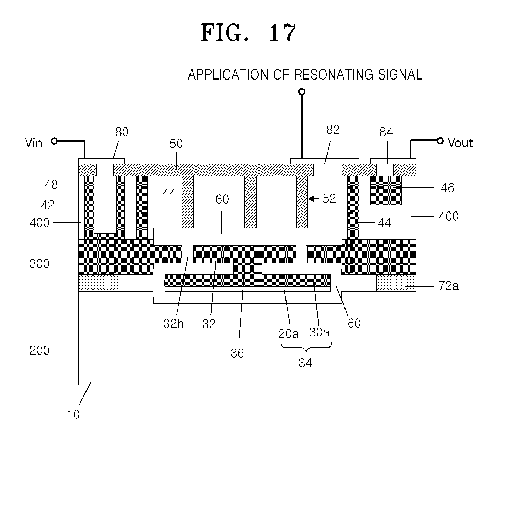

FIG. 17 is a cross-sectional view illustrating a case where the energy conversion device is used as a boost converter according to an embodiment.

Referring to FIG. 17, when an input voltage $V_{in}$ is applied to the first electrode 80 and a resonating signal is applied to the second electrode 82, an output voltage $V_{out}$ that is proportional to a change rate of a capacitance according to driving of the vibrator 32+34 may be obtained. In FIG. 17, a switch is not necessary, and the energy conversion device may be used as a DC converter having a gain of tens of decibels according to a change rate of a capacitance.

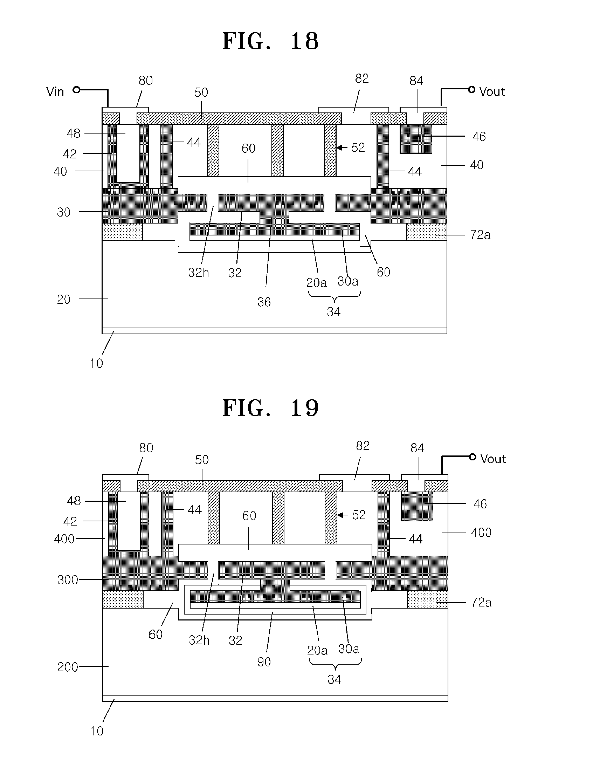

FIG. 18 is a cross-sectional view illustrating a case where the energy conversion device is used as a physical sensor according to an embodiment.

Referring to FIG. 18, in a state where an input voltage $V_{in}$ is applied to the first electrode 80 of the energy conversion device, when momentum is applied to the energy conversion device or an external force for accelerating the energy conversion device is applied to the energy conversion device, a capacitance may vary according to time. Accordingly, an output voltage $V_{out}$ according to time may be obtained by using Equation 2 below, and a momentum or an acceleration according to time may be calculated. Accordingly, the energy conversion device may be used as a sensor for calculating a physical variable according to time.

$$V_{out}(t) = [C_m(t)/ C_m(min)]V_{in} \qquad \dots \text{(Equation 2)}.$$

FIG. 19 is a cross-sectional view illustrating a case where the energy conversion device is used as an energy harvester according to an embodiment.

Referring to FIG. 19, when the energy conversion device is used as an energy harvester, a dielectric layer 90 may be further formed (i.e., provided) on a surface of the second diaphragm 34 of the energy conversion device. The dielectric layer 90 may be formed on an entire surface of the vibrator 32+34. The dielectric layer 90 may be formed before the second sealing layer 50 is formed. In this case, the dielectric layer 90 may be formed via atomic layer deposition (ALD). After the dielectric layer 90 is formed, the first sealing layer 50 and the first through third electrodes 80, 82, and 84 may be formed. In FIG. 19, the dielectric layer 90 may have fixed polarization charges. Such polarization charges may be generated by applying an external voltage to the energy conversion device. When momentum is applied to the energy conversion device of FIG. 19 when the dielectric layer 90 has fixed polarization charges, electrical energy is produced according to Equation 3 below. That is, the energy conversion device of FIG. 19 converts external mechanical energy into electrical energy.

$$V_{out}(t) = Q_{fix}/C(t) \qquad \dots \text{(Equation 3)}.$$

In Equation 3, $Q_{fix}$ denotes fixed charges generated in the dielectric layer 90.

The energy conversion device according to one or more embodiments has a monolithic single-crystal 3D structure. Accordingly, since there is no contact surface or interface between elements constituting the energy conversion device, the energy conversion device may have higher reliability than a related art energy conversion device.

Also, since all elements of the energy conversion device are formed on a single substrate (a single-crystal silicon substrate), material costs may be reduced. Since a method of manufacturing the energy conversion device according to one or more embodiments involves simply repeatedly performing epitaxial growth, doping, ion implantation, and annealing, an overall process may be simplified and used equipment may be simplified. Since the epitaxial growth, the doping, the ion implantation, and the annealing are processes used in a complementary metal-oxide-semiconductor (CMOS) process, the CMOS process may be used.

Also, the energy conversion device may be used for various purposes according to an input signal and ambient physical conditions.

In particular, when the energy conversion device is used as a boost converter, since a PN junction capacitance and a mechanical capacitance are connected and thus a high capacitance ratio is obtained, the energy conversion device may be used as a DC boost converter having a relatively high gain.

While exemplary embodiments have been particularly shown and described above, it will be understood by those of ordinary skill in the art that various changes in form and details may be made therein without departing from the scope of the present invention as defined by the following claims.

**Claims**

1. An energy conversion device comprising:

   a monolithic single-crystal silicon layer comprising a plurality of doping regions;
   a vibrator disposed in the monolithic single-crystal silicon layer and connected to a doping region of the plurality of doping regions;
   a first diode that is a PN junction diode and allows an input signal applied to the vibrator to pass therethrough; and
   a second diode that is a PN junction diode and allows a signal output from the vibrator to pass therethrough.

2. The energy conversion device of claim 1, wherein the monolithic single-crystal silicon layer comprises a space therein that is sealed, and the vibrator is disposed in the space.

3. The energy conversion device of claim 1 or 2, wherein:

   the plurality of doping regions comprises a first doping region, a second doping region, and a third doping region that are sequentially disposed and the third doping region comprises a p-type doping region and n-type doping regions that form the first diode and the second diode; and
   a doping region that separates a remaining portion of the third doping region and the first diode and the second diode.

4. The energy conversion device of claim 3, wherein:

   the third doping region further comprises a plurality of through-holes that are connected to the space.

5. The energy conversion device of claim 4, further comprising a sealing layer that is disposed on the third doping region to cover the plurality of through-holes.

6. The energy conversion device of claim 5, wherein the sealing layer comprises a plurality of contact holes through which the first diode, the second diode, and a portion of the third doping region between the first diode and the second diode are exposed.

7. The energy conversion device of claim 6, further comprising:

a first electrode, a second electrode, and a third electrode disposed on the sealing layer to be spaced apart from each other,
wherein the first electrode, the second electrode, and the third electrode are connected to the first diode, the second diode, and the third doping region through the plurality of contact holes.

8. The energy conversion device of any of claims 3 to 7, wherein adjacent doping regions among the first doping region, the second doping region, and the third doping region are oppositely doped.

9. The energy conversion device of any preceding claim, wherein the vibrator comprises a first diaphragm and a second diaphragm that are connected to each other.

10. The energy conversion device of any preceding claim, wherein the vibrator comprises a first portion that is doped to have a same conductivity as a conductivity of the doping region to which the vibrator is connected, and a second portion that is doped to have a same conductivity as conductivities of doping regions to which the vibrator is not connected.

11. The energy conversion device of claim 9 or 10, wherein the second diaphragm comprises a first portion and a second portion that are oppositely doped.

12. The energy conversion device of claim 9, 10 or 11, wherein the first diaphragm comprises a plurality of through-holes.

13. The energy conversion device of claim 11 or 12, wherein a doping region facing the second diaphragm and the vibrator constitute a variable capacitor.

14. The energy conversion device of claim 13, wherein the second diaphragm and the doping region facing the second diaphragm are parallel to each other at all times during operation of the energy conversion device.

15. The energy conversion device of any preceding claim, further comprising an insulating layer that has fixed polarization charges and is disposed on a surface of the vibrator.

16. A method of operating an energy conversion device according to any preceding claim, the method comprising:

driving the vibrator; and
outputting, through the second diode, an output signal according to the driving of the vibrator.

17. The method of claim 16, wherein the driving of the vibrator comprises applying an input voltage to the first diode.

18. The method of claim 17, further comprising applying a synchronizing signal to a region that is electrically separated from the first diode and the second diode in a doping region between the first diode and the second diode to cause the output signal to be higher than the input voltage.

19. The method of claim 16, wherein the vibrator is driven by a force applied to the energy conversion device, and the output signal is data for measuring a physical quantity of the force.

20. The energy conversion device of claim 1, wherein a voltage of the signal output through the second diode is greater than a voltage of the input signal.

21. The energy conversion device of claim 20, wherein the voltage of the signal output through the second diode is greater than the voltage of the input signal according to:

$$V_{out} = [C_m(max)/ C_m(min)]V_{in},$$

where $V_{out}$ is the voltage of the signal output through the second diode, $V_{in}$ is the voltage of the input signal, $C_m$(max) is a maximum capacitance of a capacitor comprising the vibrator and a first doping region, among the plurality of doping regions, and $C_m$(min) is a minimum capacitance of the capacitor.

22. A method of manufacturing an energy conversion device, the method comprising:

forming a first oxidized region on a first silicon layer that is a single-crystal silicon layer and is doped with a first-type doping material;
growing, on the first silicon layer, a second silicon layer that is doped with a second-type doping material;
forming a second oxidized region that is connected to the first oxidized region and surrounds a portion of the first silicon layer and a portion of the second silicon layer, wherein the portion of the second silicon layer surrounded by the second oxidized region is connected to a portion of the second silicon layer formed over the second oxidized region;
growing, on the second silicon layer, a third silicon layer that is a single-crystal layer and is doped with the first-type doping material;
forming, on the portion of the second silicon layer formed over the second oxidized region, a third oxidized region that is connected to the second oxidized region, wherein the third oxidized region is formed by oxidizing a top surface of the second silicon layer;
forming, on the third silicon layer, a first PN junction diode and a second PN junction diode that are spaced apart from the third oxidized region and are electrically separated from each other by a remaining portion of the third silicon layer;
forming a vibrator that is spaced apart from the first silicon layer and the third silicon layer and is connected to only the second silicon layer by removing oxides of the first oxidized region, the second oxidized region, and the third oxidized region; and
sealing portions from which the oxides are removed,
wherein the second silicon layer and the third silicon layer are formed by using epitaxial growth, and
wherein the first-type doping material is one of a p-type doping material and an n-type doping material, and the second-type doping material is the other one of the p-type doping material and the n-type doping material.

23. The method of claim 22, wherein the forming of the second oxidized region comprises:

forming a fourth oxidized region that is connected to the first oxidized region at a position higher than a position of the first oxidized region outside the first oxidized region; and
forming a fifth oxidized region that is connected to the fourth oxidized region to be parallel to the first oxidized region at a position higher than the position of the fourth oxidized region over and within the first oxidized region, wherein a middle portion of the fifth oxidized region is a non-oxidized portion.

24. The method of claim 22 or 23, wherein the forming of the third oxidized region comprises:

forming, on the second silicon layer, a sixth oxidized region that is connected to the second oxidized region, at a position higher than a position of the second oxidized region; and
forming, on the second silicon layer, a seventh oxidized region that is connected to the sixth oxidized region, at a position higher than the position of the sixth oxidized region, wherein the seventh oxidized region is formed by oxidizing the entire second silicon layer between the sixth oxidized region and the third silicon layer.

25. The method of claim 24, wherein the seventh oxidized region extends to the third silicon layer.

26. The method of claim 22, 23, 24 or 25, wherein the forming of the first PN junction diode and the second PN junction diode comprises:

forming a first n-type doping region that is connected to the second silicon layer and is spaced apart from the third oxidized region, on the third silicon layer at a side of the third oxidized region;
forming a second n-type doping region that is connected to the second silicon layer and is spaced apart from the first n-type doping region, on the third silicon layer between the third oxidized region and the first n-type doping region, wherein the second n-type doping region is formed on the third silicon layer at the side of the third oxidized region;

forming a third n-type doping region that is not connected to the second n-type doping region and the second silicon layer outside the second n-type doping region on the third silicon layer at another side of the third oxidized region; and

forming a p-type doping region on the first n-type doping region formed on the third silicon layer at the side of the third oxidized region,

wherein the first n-type doping region and the second n-type doping region are simultaneously formed.

27. The method of any of claims 22 to 26, wherein the forming of the vibrator comprises:

forming through-holes, through which the third oxidized region is exposed, in the third silicon layer; and
wet etching oxides of the first oxidized region, the second oxidized region, and the third oxidized region through the through-holes.

28. The method of any of claims 22 to 27, wherein the first oxidized region, the second oxidized region, and the third oxidized region are formed by:

implanting oxygen ions; and
annealing a resultant structure obtained after the implanting the oxygen ions.

29. The method of claim 27 or 28, wherein the sealing comprises forming a sealing layer that is formed on the third silicon layer to seal the through-holes.

30. The method of claim 29, further comprising:

forming, on the sealing layer, a plurality of through-holes, through which the first PN junction diode and the second PN junction diode are exposed and through which the third silicon layer between the first PN junction diode and the second PN junction diode is exposed; and

forming, on the sealing layer, a first electrode that is connected to the exposed first PN junction diode, a second electrode that is connected to the exposed second PN junction diode, and a third electrode that is connected to the exposed third silicon layer.

FIG. 1

FIG. 2

# FIG. 3

# FIG. 4

FIG. 5

300

70a

200

FIG. 6

72

M2

300

72a

70a

200

FIG. 7A

74

M3

300

74a

72a

70a

200

FIG. 7B

7

7'

M3

M3

300

EP 2 566 037 A2

FIG. 8

400

300 — 74a

72a

70a

200

FIG. 9

76

M4

400

76a  76a

300 — 74a

72a

70a

200

18

# FIG. 10

78

M5

400

78a

76a    76a

74a

300

72a

70a

200

# FIG. 11

46

42    44    44

400

78a

76a    76a

300    74a

72a

70a

200

## FIG. 12

## FIG. 13

# FIG. 14

# FIG. 15

## FIG. 16

# FIG. 17

APPLICATION OF RESONATING SIGNAL

# FIG. 18

# FIG. 19